# EUROPEAN PATENT SPECIFICATION

(11) **EP 2 929 806 B1**
(45) Date of publication and mention of the grant of the patent: **11.10.2017**
(21) Application number: 14163981.5
(22) Date of filing: 09.04.2014
(51) Int. Cl.: A47B 88/43, H05K 7/14

(54) **System comprising a slide rail assembly**
System mit Schienenanordnung
Système comprenant un ensemble de rails de glissement

(43) Date of publication of application: 14.10.2015
(73) Proprietor: King Slide Works Co., Ltd., Kaohsiung City (TW); King Slide Technology Co., Ltd., Kaohsiung City (TW)
(72) Inventor: Chen, Ken-Ching, Kaohsiung City (TW); Yang, Shun-Ho, Kaohsiung City (TW); Ho, Chun-Yi, Kaohsiung City (TW); Wang, Chun-Chiang, Kaohsiung City (TW)
(74) Representative: Viering, Jentschura & Partner mbB Patent- und Rechtsanwälte

(56) References cited:
- DE-A1-102009 014 894
- US-A- 6 145 945
- US-A1- 2004 119 388
- US-B1- 6 997 529

## Description

### Field of the Invention

The present invention relates to a system comprising a slide rail assembly and more particularly to a system comprising a slide rail assembly two rails of which can slide relative to each other by means of a ball assembly without the mounting member on a lateral side of a chassis colliding with one end of a lateral portion of the ball assembly due to installation errors.

### Background of the Invention

With the development of the Internet and the prevalence of personal mobile devices, the storage of electronic information or data is becoming more and more important. In particular, servers can be used to store a vast amount of such electronic information or data to meet the need of data storage. Generally speaking, a server (e.g., a rack server) is installed in a chassis, and the chassis is mounted on a rack via a pair of slide rail assemblies each composed of two or three slide rails. Thus, the installation of the server on the rack is completed.

Some slide rail assemblies in the prior art are equipped with ball retainers, each containing a plurality of balls, so that slidably connected slide rails can displace relative to one another via the balls. Such slide rail assemblies are disclosed, for example, in US Patent Nos. 6,988,626 and 6,379,045, which are referenced when the present invention was made.

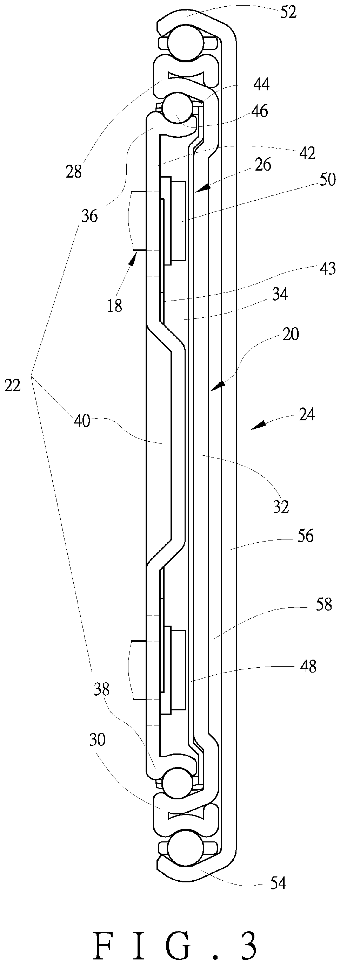

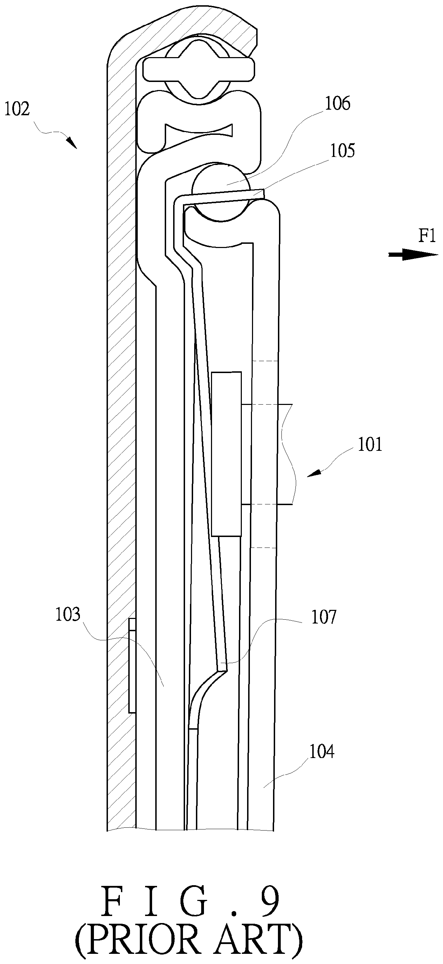

As the chassis of a server is mounted and positioned on the slide rails (e.g., the inner rails) of a pair of the foregoing slide rail assemblies (i.e., those with ball retainers and balls) typically through the mounting members provided on the lateral sides of the chassis (e.g., the screws 62 in FIG. 3 and FIG. 9 of the aforesaid '626 patent), the size or specifications of the mounting members must be within predetermined allowable installation errors of the slide rail assemblies; otherwise, the mounting members on the lateral sides of the chassis of the server may bump into the ends of the ball retainers, which are located between slidably connected slide rails, when the slide rails are displaced relative to one another. Should the ball retainers be deformed as a result, the slide rails of the slide rail assemblies will have problem being displaced smoothly.

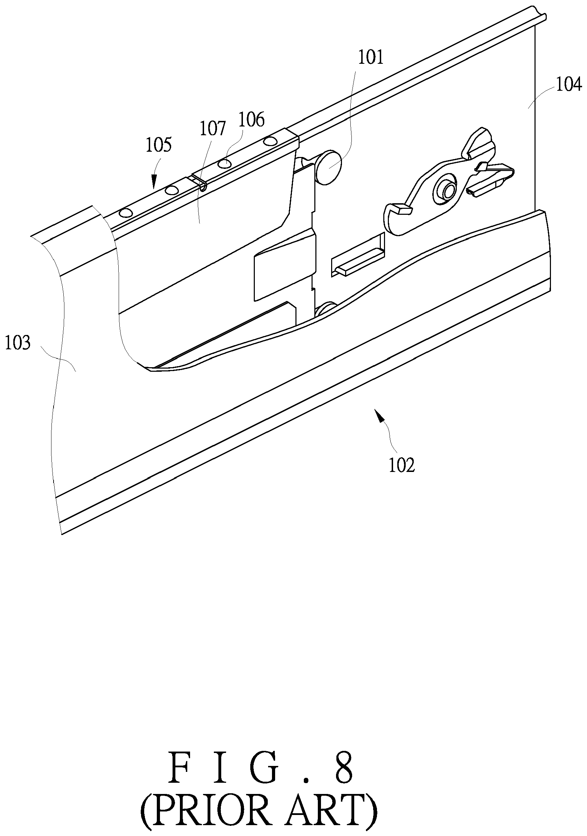

More specifically, referring to FIG. 8, a chassis (not shown) is mounted on a slide rail assembly 102 via at least one mounting member 101. The slide rail assembly 102 at least includes two slide rails (e.g., a first rail 103 and a second rail 104) and a ball retainer 105 which is disposed between the first rail 103 and the second rail 104. The ball retainer 105 is equipped with a plurality of balls 106 by means of which the first rail 103 and the second rail 104 can slide relative to each other. The chassis is mounted on the second rail 104 via the mounting member 101. When the second rail 104 is slid in a longitudinal direction relative to the first rail 103, the chassis is slid along with the second rail 104 in the longitudinal direction relative to the first rail 103 due to the mounting member 101.

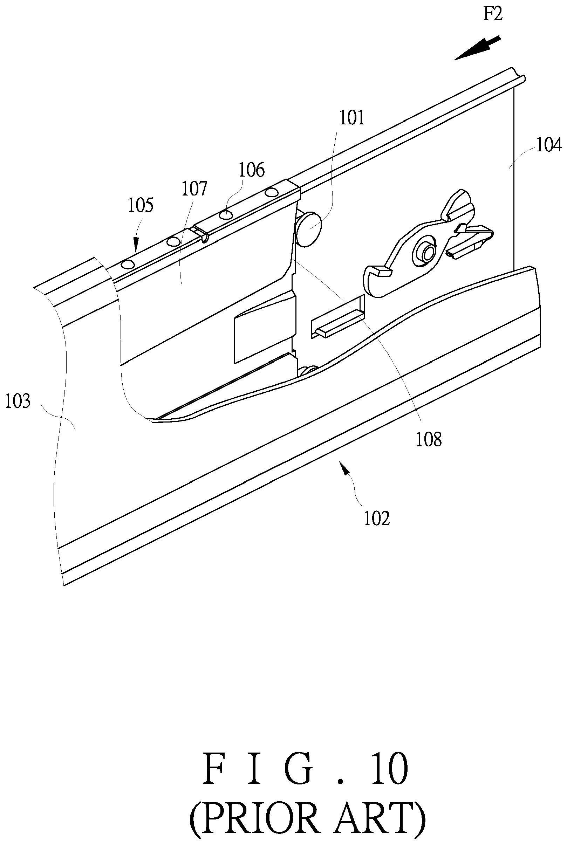

Referring to FIG. 9 and FIG. 10 in conjunction with FIG. 8, when the slide rail assembly 102 mounted with the chassis (FIG. 8 to FIG. 10 showing only the mounting member 101 of the chassis) is installed on a rack, the ball retainer 105 of the slide rail assembly 102 may be deformed if the total weight of the chassis and the electronic components therein is too great. Once such deformation takes place, the lateral portion 107 of the ball retainer 105 may be tilted in a lateral direction F1 (i.e., toward the mounting member 101), as shown in FIG. 9, and when the second rail 104 is pulled in a longitudinal direction F2 relative to the first rail 103 from an initial position (see FIG. 8) to the position shown in FIG. 10, the mounting member 101 on the second rail 104 may collide with the end 108 of the lateral portion 107 of the ball retainer 105, thereby deforming the ball retainer 105 and hindering the second rail 104 from sliding relative to the first rail 103. Even worse, the slide rail assembly 102 may be damaged.

DE 10 2009 014 894 A1 discloses a slide rail assembly comprising a first rail and a second rail movably connected to the first rail. Further, the slide rail assembly comprises a ball retainer between the first rail and the second rail.

US 6,997,529 B1 discloses a slide rail assembly with a first rail, a second rail and a ball retainer. The first rail and the second rail are moveably connected to each other.

US 2004/119388 A1 discloses a system comprising a slide rail assembly according to the preamble of claim 1. The slide rail assembly includes a first rail, a second rail, and a ball assembly. The first rail has a longitudinally extending main body. The second rail has a longitudinally extending main body and is slidably connected to the longitudinally extending main body of the first rail. The ball assembly includes a ball retainer and a plurality of balls arranged in the ball retainer. The ball assembly is movably mounted between the longitudinally extending main body of the first rail and the longitudinally extending main body of the second rail so that the first rail and the second rail can slide relative to each other via the balls in contact with the rails. The ball retainer includes a lateral portion corresponding in position to the space between the longitudinally extending main body of the first rail and the longitudinally extending main body of the second rail. The longitudinally extending main body of the second rail further includes a projecting block for pushing the lateral portion of the ball retainer and thereby keeping the lateral portion of the ball retainer close to the longitudinally extending main body of the first rail.

### Summary of the Invention

The present invention is related to a system comprising a slide rail assembly according to claim 1.

The system comprising a slide rail assembly includes a first rail, a second rail, and a ball assembly. The first rail has a longitudinally extending main body. The second rail has a longitudinally extending main body and is slidably connected to the longitudinally extending main body of the first rail. The ball assembly includes a ball retainer and a plurality of balls arranged in the ball retainer. The ball assembly is movably mounted between the longitudinally extending main body of the first rail and the longitudinally extending main body of the second rail so that the first rail and the second rail can slide relative to each other via the balls in contact with the rails. The ball retainer includes a lateral portion corresponding in position to the space between the longitudinally extending main body of the first rail and the longitudinally extending main body of the second rail. The longitudinally extending main body of the second rail further includes a projecting block for pushing the lateral portion of the ball retainer and thereby keeping the lateral portion of the ball retainer close to the longitudinally extending main body of the first rail. The second rail (22) includes an upper wall (36), a lower wall (38) opposite to the upper wall (36), and a sidewall (40) connected between the upper wall (36) and the lower wall (38). The sidewall of the second rail has at least one mounting portion, and a block member is mounted on the sidewall of the second rail. The system further comprises a chassis. The chassis comprises a mounting member and the at least one mounting portion is configured to be mounted to the mounting member provided on at least one lateral side of the chassis to be connected and fixed to the second rail of the slide rail assembly. The block member can be pressed against the mounting member when the mounting member is mounted at the mounting portion of the sidewall of the second rail.

The system comprising the slide rail assembly has a ball assembly to facilitate relative movement of two slidably connected rails and which can prevent the mounting member on a lateral side of a chassis from colliding with one end of a lateral portion of the ball assembly during such movement.

Preferably the system comprising the slide rail assembly is served to mount a lateral side of the chassis to a rack, the lateral side of the chassis being equipped with the at least one mounting member. The mounting member includes a first end portion and a second end portion opposite to the first end portion. The first end portion is connected to the lateral side of the chassis, and the second end portion is transversely mounted on the longitudinally extending main body of the second rail. When transversely mounted on the longitudinally extending main body of the second rail, the second end portion is located between the longitudinally extending main body of the second rail and the longitudinally extending main body of the first rail. There is a transverse first distance between a wall surface of the longitudinally extending main body of the second rail and a surface of the second end portion of the mounting member, and there is a transverse second distance between the wall surface of the longitudinally extending main body of the second rail and a pushing surface of the projecting block, wherein the second distance is greater than the first distance.

Preferably the longitudinally extending main body of the first rail includes an upper wall, a lower wall opposite to the upper wall, and a sidewall connected between the upper wall and the lower wall. The upper wall, the lower wall, and the sidewall of the longitudinally extending main body of the first rail define a longitudinal channel. The longitudinally extending main body of the second rail is slidably received in the longitudinal channel of the first rail. The second rail includes an upper wall, a lower wall opposite to the upper wall, and a sidewall connected between the upper wall and the lower wall. The sidewall of the longitudinally extending main body of second rail has a mounting portion. The lateral portion of the ball retainer corresponds in position to a space between the sidewall of the longitudinally extending main body of first rail and the sidewall of the longitudinally extending main body of the second rail. The projecting block is located on the sidewall of the longitudinally extending main body of the second rail for pushing the lateral portion of the ball retainer and thereby keeping the lateral portion of the ball retainer close to the sidewall of the longitudinally extending main body of the first rail.

Preferably, the projecting block of the sidewall of the second rail includes an inclined surface and a pushing surface. When the second rail is pulled in a longitudinal direction relative to the first rail, the lateral portion of the ball retainer is guided by the inclined surface in order for the pushing surface to push the lateral portion of the ball retainer.

Preferably, the system comprising the slide rail assembly further includes a third rail. The third rail includes an upper wall, a lower wall opposite to the upper wall, and a sidewall connected between the upper wall and the lower wall. The upper wall, the lower wall, and the sidewall of the third rail define a longitudinal channel. The first rail is slidably connected in the longitudinal channel of the third rail.

According to one aspect of the present invention, a system comprising the slide rail assembly for mounting a lateral side of a chassis to a rack is provided, wherein the lateral side of the chassis is equipped with at least one mounting member. The slide rail assembly includes a first rail, a second rail, and a ball assembly. The first rail includes an upper wall, a lower wall opposite to the upper wall, and a sidewall connected between the upper wall and the lower wall. The upper wall, the lower wall, and the sidewall of the first rail define a longitudinal channel. The second rail, which is slidably connected in the longitudinal channel of the first rail, includes an upper wall, a lower wall opposite to the upper wall, and a sidewall connected between the upper wall and the lower wall. The sidewall of the second rail has a mounting portion to be mounted to the mounting member on the lateral side of the chassis. The ball assembly includes a ball retainer and a plurality of balls arranged in the ball retainer. The ball assembly is movably mounted between the first rail and the second rail. The ball retainer includes a lateral portion corresponding in position to the space between the sidewall of the first rail and the sidewall of the second rail. The sidewall of the second rail further includes a projecting block for pushing the lateral portion of the ball retainer and thereby keeping the lateral portion of the ball retainer close to the sidewall of the first rail.

Preferably, the projecting block of the sidewall of the second rail includes an inclined surface and a pushing surface. When the second rail is pulled in a longitudinal direction relative to the first rail, the lateral portion of the ball retainer is guided by the inclined surface in order for the pushing surface to push the lateral portion of the ball retainer.

Preferably, the mounting member includes a first end portion and a second end portion opposite to the first end portion. The first end portion is connected to the lateral side of the chassis, and the second end portion is mounted at the mounting portion of the sidewall of the second rail. When mounted at the mounting portion of the sidewall of the second rail, the second end portion is located between the sidewall of the second rail and the sidewall of the first rail. There is a first distance between a wall surface of the sidewall of the second rail and a surface of the second end portion of the mounting member, and there is a second distance between the wall surface of the sidewall of the second rail and a pushing surface of the projecting block, wherein the second distance is greater than the first distance and the pushing surface is provided to push the lateral portion of the ball retainer.

Preferably, the system comprising the slide rail assembly further includes a third rail. The third rail includes an upper wall, a lower wall opposite to the upper wall, and a sidewall connected between the upper wall and the lower wall. The upper wall, the lower wall, and the sidewall of the third rail define a longitudinal channel. The first rail is slidably connected in the longitudinal channel of the third rail.

### Brief Description of the Drawings

The invention as well as a preferred mode of use and the advantages thereof will be best understood by referring to the following detailed description of some illustrative embodiments in conjunction with the accompanying drawings, wherein:
FIG. 1 schematically shows how a chassis is mounted on a rack via the slide rail assemblies in one embodiment of the present invention;
FIG. 2 is a perspective view showing how the components of the slide rail assembly in one embodiment of the present invention are arranged;
FIG. 3 is a front view of the slide rail assembly in one embodiment of the present invention;
FIG. 4 is a perspective view showing in particular the projecting block on a sidewall of the second rail in the slide rail assembly in one embodiment of the present invention;
FIG. 5 is a schematic drawing showing how the second rail in the slide rail assembly in one embodiment of the present invention is slid relative to the first rail;
FIG. 6 is another schematic drawing showing how the second rail in the slide rail assembly in one embodiment of the present invention is slid relative to the first rail;
FIG. 7 is yet another schematic drawing showing how the second rail in the slide rail assembly in one embodiment of the present invention is slid relative to the first rail;
FIG. 8 is a perspective view showing how a chassis is mounted on a prior art slide rail assembly via a mounting member;
FIG. 9 schematically shows how a mounting member collides with a ball retainer in the prior art; and
FIG. 10 is a perspective view showing how a mounting member collides with a ball retainer in the prior art when being displaced.

### Detailed Description of the Invention

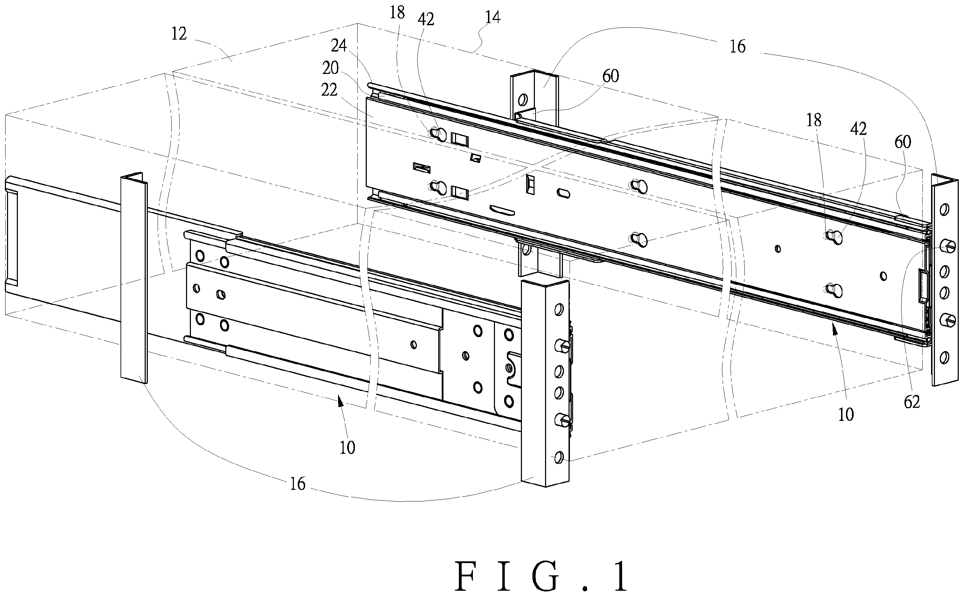

FIG. 1 shows a pair of slide rail assemblies 10 mounted on two lateral sides 14 of a chassis 12 respectively, and the chassis 12 is installed on a rack 16 via the slide rail assemblies 10. In one preferred embodiment, at least one lateral side 14 of the chassis 12 is equipped with at least one mounting member 18.

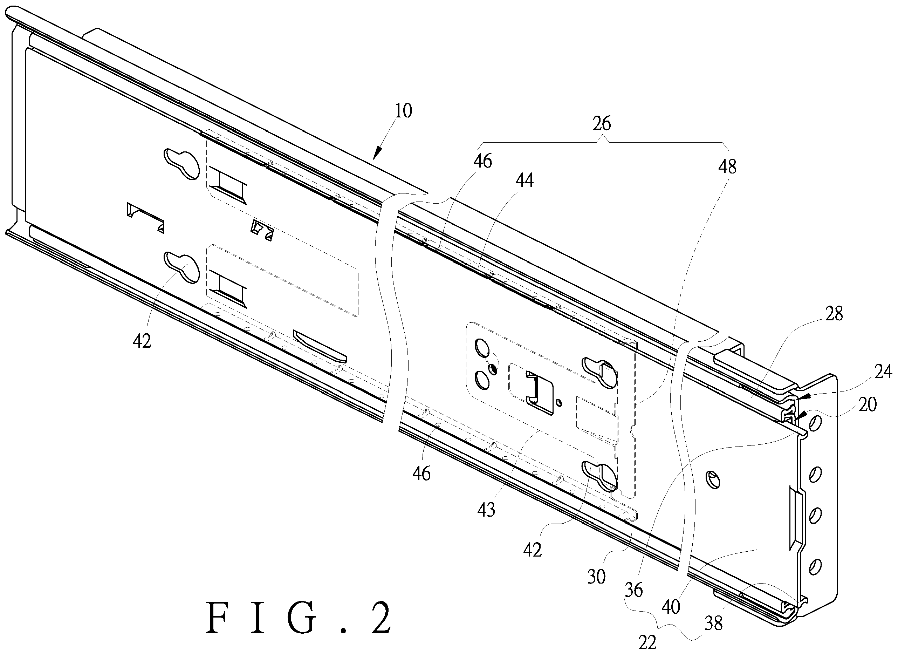

As shown in FIG. 2, the slide rail assembly 10 includes a first rail 20, a second rail 22, and a ball assembly 26. Preferably, the slide rail assembly 10 further includes a third rail 24 to complete a three-rail configuration, in which the first rail 20 serves as the middle rail, the second rail 22 as the inner rail, and the third rail 24 as the outer rail. However, the arrangement of the rails is not limited to the foregoing. Each of the first rail 20, the second rail 22, and the third rail 24 has a longitudinally extending main body.

Referring to FIG. 3, the first rail 20 includes an upper wall 28, a lower wall 30 opposite to the upper wall 28, and a sidewall 32 connected between the upper wall 28 and the lower wall 30. The upper wall 28, lower wall 30, and sidewall 32 of the first rail 20 define a longitudinal channel 34.

The second rail 22 is slidably connected in the longitudinal channel 34 of the first rail 20. The second rail 22 includes an upper wall 36, a lower wall 38 opposite to the upper wall 36, and a sidewall 40 connected between the upper wall 36 and the lower wall 38. The sidewall 40 has at least one mounting portion 42. The mounting portion 42 is configured to be mounted to the mounting member 18 on the lateral side 14 of the chassis 12 (shown in FIG. 1).

The third rail 24 includes an upper wall 52, a lower wall 54 opposite to the upper wall 52, and a sidewall 56 connected between the upper wall 52 and the lower wall 54. The upper wall 52, lower wall 54, and sidewall 56 of the third rail 24 define a longitudinal channel 58. The first rail 20 is slidably connected in the longitudinal channel 58 of the third rail 24. In addition, as shown in FIG. 1, the slide rail assembly 10 includes two brackets 60 mounted respectively at a front position and a rear position on the third rail 24. Each bracket 60 is fixed to the rack 16 via at least one fixing element 62 such that the slide rail assembly 10 is fixed to the rack 16.

The ball assembly 26 includes a ball retainer 44 and a plurality of balls 46 arranged in the ball retainer 44. The ball assembly 26 is movably mounted between the first rail 20 and the second rail 22 in such a way that the balls 46 are located between the first rail 20 and the second rail 22 to facilitate relative sliding of the first rail 20 and the second rail 22. The ball retainer 44 includes a lateral portion 48 corresponding in position to the space between the sidewall 32 of the first rail 20 and the sidewall 40 of the second rail 22.

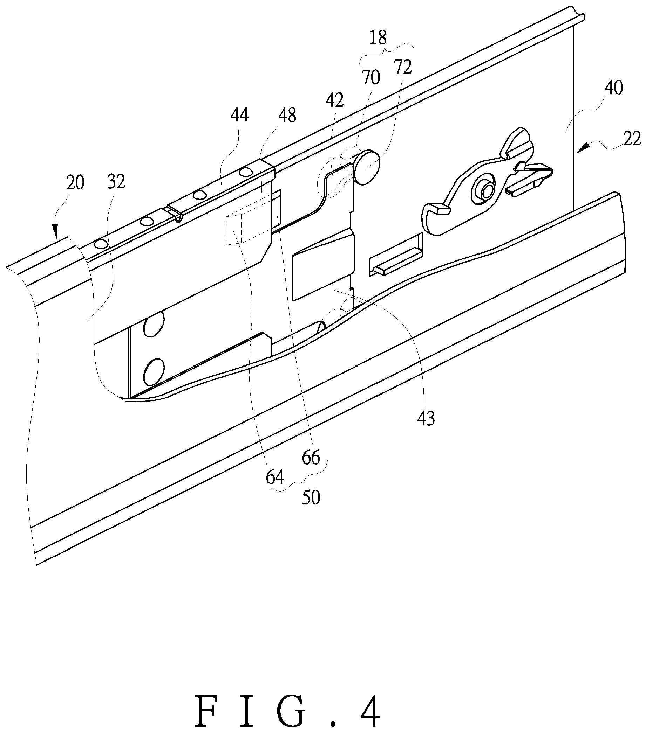

As shown in FIG. 4, the sidewall 40 of the second rail 22 further includes a projecting block 50. The projecting block 50 is configured to push the lateral portion 48 of the ball retainer 44, thereby keeping the lateral portion 48 of the ball retainer 44 close to the sidewall 32 of the first rail 20. The projecting block 50 preferably includes an inclined surface 64 and a pushing surface 66.

More specifically, the mounting member 18 on the lateral side 14 of the chassis 12 (shown in FIG. 1) is mounted at the mounting portion 42 of the sidewall 40 of the second rail 22. In addition, a block member 43 is mounted on the sidewall 40 of the second rail 22. After the mounting member 18 is mounted at the mounting portion 42 of the sidewall 40 of the second rail 22, the block member 43 is pressed against the mounting member 18, allowing the chassis 12 to be connected and fixed to the second rail 22 of the slide rail assembly 10. The slide rail assembly 10 mounted with the chassis 12 is then positioned on the rack 16 via the brackets 60 on the third rail 24, as shown in FIG. 1.

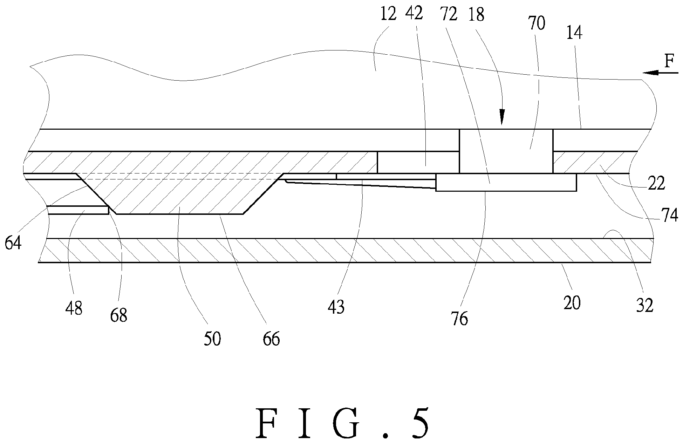

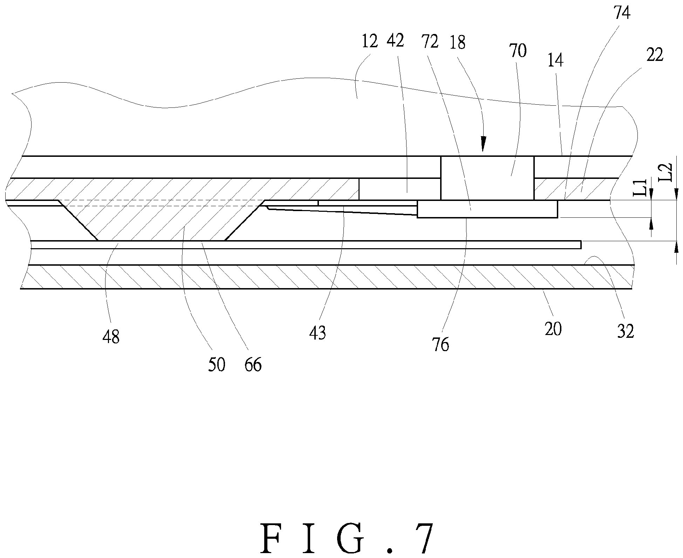

Referring to FIG. 5, FIG. 6, and FIG. 7, when the second rail 22 mounted with the chassis 12 is pulled in a longitudinal direction F relative to the first rail 20, the lateral portion 48 of the ball retainer 44 is guided by the inclined surface 64 of the projecting block 50 in order for the pushing surface 66 of the projecting block 50 to push the lateral portion 48 of the ball retainer 44, keeping the lateral portion 48 of the ball retainer 44 close to the sidewall 32 of the first rail 20. Therefore, when the second rail 22 is displaced in the longitudinal direction F (see FIG. 5), the mounting member 18 will not collide with the end 68 of the lateral portion 48 of the ball retainer 44, even if the size issue happens or the lateral portion 48 of the ball retainer 44 is tilted by the weight of the chassis 12. The ball retainer 44 is thus protected from deformation. In this way, the slide rails (e.g., the first rail 20 and the second rail 22) of the slide rail assembly 10 are able to slide smoothly relative to each other.

The mounting member 18 includes a first end portion 70 and a second end portion 72 opposite to the first end portion 70. The first end portion 70 is connected to the lateral side 14 of the chassis 12. The second end portion 72 is transversely mounted at the mounting portion 42 of the sidewall 40 of the second rail 22. The first end portion 70 and the second end portion 72 may be cylindrical, and the second end portion 72 is greater in diameter than the first end portion 70. However, the configurations of the first end portion 70 and the second end portion 72 are not limited to the above.

When transversely mounted at the mounting portion 42 of the sidewall 40 of the second rail 22, the second end portion 72 is restricted at the mounting portion 42 by the block member 43. There is a transverse first distance L1 between a wall surface 74 of the sidewall 40 of the second rail 22 (i.e., the wall surface facing the first rail 20) and a surface 76 of the second end portion 72 of the mounting member 18. There is a transverse second distance L2 between the wall surface 74 of the sidewall 40 of the second rail 22 and the pushing surface 66 of the projecting block 50. The second distance L2 is greater than the first distance L1.

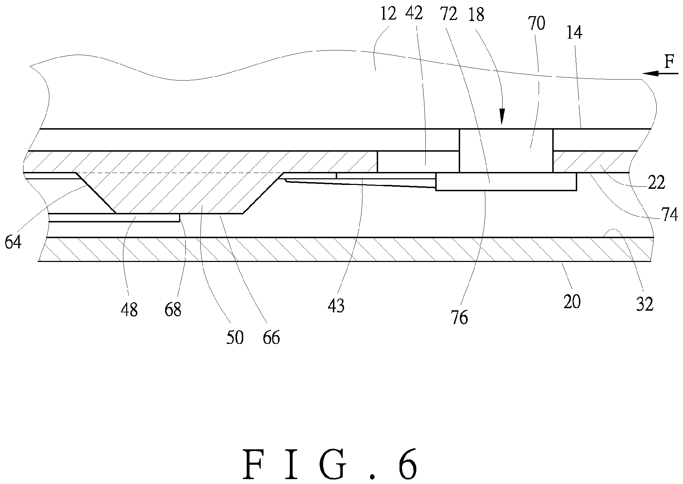

Thus, when the second rail 22 is slid in the longitudinal direction F (see FIGS. 5 and 6), the mounting member 18 is not able to collide with the end 68 of the lateral portion 48 of the ball retainer 44. As such, the ball retainer 44 is protected from deformation, and the slide rails (e.g., the first rail 20 and the second rail 22) of the slide rail assembly 10 thus are able to slide smoothly relative to each other.

While the present invention has been disclosed through the preferred embodiments described above, the embodiments are not intended to limit the scope of the present invention. The scope of the present invention is defined only by the appended claims.

## Claims

1. System comprising a slide rail assembly (10),
the slide rail assembly (10), comprising:
a first rail (20) having a longitudinally extending main body;
a second rail (22) having a longitudinally extending main body and slidably connected to the longitudinally extending main body of the first rail (20); and
a ball assembly (26) comprising a ball retainer (44) and a plurality of balls (46) arranged in the ball retainer (44), the ball assembly (26) being movably mounted between the first rail (20) and the second rail (22), the ball retainer (44) comprising a lateral portion (48) corresponding in position to a space between the longitudinally extending main body of the first rail (20) and the longitudinally extending main body of the second rail (22);
wherein the longitudinally extending main body of the second rail (22) further comprises a projecting block (50) for pushing the lateral portion (48) of the ball retainer (44) and thereby keeping the lateral portion (48) of the ball retainer (44) close to the longitudinally extending main body of the first rail (20), wherein the second rail (22) includes an upper wall (36), a lower wall (38) opposite to the upper wall (36), and a sidewall (40) connected between the upper wall (36) and the lower wall (38),
wherein the sidewall (40) of the second rail (22) has at least one mounting portion (42), and a block member (43) is mounted on the sidewall (40) of the second rail (22),
**characterized in,**
**that** the system further comprises a chassis (12), the chassis (12) comprises a mounting member (18), and
**that** the at least one mounting portion (42) is configured to be mounted to the mounting member (18) provided on at least one lateral side of the chassis (12) to be connected and fixed to the second rail (22) of the slide rail assembly (10), and
**that** the block member (43) can be pressed against the mounting member (18) when the mounting member (18) is mounted at the mounting portion (42) of the sidewall (40) of the second rail (22).

2. System according to claim 1, wherein the slide rail assembly (10) is served to mount a lateral side (14) of the chassis (12) to a rack (16), the lateral side (14) of the chassis (12) being equipped with the at least one mounting member (18), and wherein the mounting member (18) comprises a first end portion (70) and a second end portion (72) opposite to the first end portion (70), the first end portion (70) being connected to the lateral side (14) of the chassis (12), the second end portion (72) being transversely mounted on the longitudinally extending main body of the second rail (22), the second end portion (72) being located between the longitudinally extending main body of the second rail (22) and the longitudinally extending main body of the first rail (20) when transversely mounted on the longitudinally extending main body of the second rail (22), there being a transverse first distance (L1) between a wall surface (74) of the longitudinally extending main body of the second rail (22) and a surface (76) of the second end portion (72) of the mounting member (18), there being a transverse second distance (L2) between the wall surface (74) of the longitudinally extending main body of the second rail (22) and a pushing surface (66) of the projecting block (50), the second distance (L2) being greater than the first distance (L1).

3. System according to claim 1, wherein the longitudinally extending main body of the first rail (20) comprises an upper wall (28), a lower wall (30) opposite to the upper wall (28), and a sidewall (32) connected between the upper wall (28) and the lower wall (30), and wherein the upper wall (28), the lower wall (30), and the sidewall (32) of the longitudinally extending main body of the first rail (20) define a longitudinal channel (34);
wherein the longitudinally extending main body of the second rail (22) is slidably received in the longitudinal channel (34) of the first rail (20) and comprises an upper wall (36), a lower wall (38) opposite to the upper wall (36), and the sidewall (40) connected between the upper wall (36) and the lower wall (38), the sidewall (40) of the longitudinally extending main body of the second rail (22) including the mounting portion (42);
wherein the lateral portion (48) of the ball retainer (44) corresponds in position to a space between the sidewall (32) of the longitudinally extending main body of the first rail (20) and the sidewall (40) of the longitudinally extending main body of the second rail (22); and
wherein the projecting block (50) is located on the sidewall (40) of the longitudinally extending main body of the second rail (22) for pushing the lateral portion (48) of the ball retainer (44) and thereby keeping the lateral portion (48) of the ball retainer (44) close to the sidewall (32) of the longitudinally extending main body of the first rail (20).

4. System according to claim 3, wherein the projecting block (50) on the sidewall (40) of the longitudinally extending main body of the second rail (22) comprises an inclined surface (64) and a pushing surface (66), and when the second rail (22) is pulled in a longitudinal direction (F) relative to the first rail (20), the lateral portion (48) of the ball retainer (44) is guided by the inclined surface (64) in order for the pushing surface (66) to push the lateral portion (48) of the ball retainer (44).

5. System according to claim 3, further comprising a third rail (24), the third rail (24) comprising an upper wall (52), a lower wall (54) opposite to the upper wall (52), and a sidewall (56) connected between the upper wall (52) and the lower wall (54), wherein the upper wall (52), the lower wall (54), and the sidewall (56) of the third rail (24) define a longitudinal channel (58), the first rail (20) being slidably connected in the longitudinal channel (58) of the third rail (24).

6. System according to claim 1, wherein the slide rail assembly (10) is served to mount a lateral side (14) of the chassis (12) to a rack (16), the lateral side (14) of the chassis (12) being equipped with the at least one mounting member (18);
wherein the longitudinally extending main body of the first rail (20) comprises an upper wall (28), a lower wall (30) opposite to the upper wall (28), and a sidewall (32) connected between the upper wall (28) and the lower wall (30), and wherein the upper wall (28), the lower wall (30), and the sidewall (32) of the longitudinally extending main body of the first rail (20) define a longitudinal channel (34);
wherein the longitudinally extending main body of the second rail (22) is slidably received in the longitudinal channel (34) of the first rail (20) and comprises an upper wall (36), a lower wall (38) opposite to the upper wall (36), and the sidewall (40) connected between the upper wall (36) and the lower wall (38), the sidewall (40) of the longitudinally extending main body of the second rail (22) including the mounting portion (42) to be mounted to the mounting member (18) on the lateral side (14) of the chassis (12);
wherein the lateral portion (48) of the ball retainer (44) corresponds in position to a space between the sidewall (32) of the longitudinally extending main body of the first rail (20) and the sidewall (40) of the longitudinally extending main body of the second rail (22); and
wherein the projecting block (50) is located on the sidewall (40) of the longitudinally extending main body of the second rail (22) for pushing the lateral portion (48) of the ball retainer (44) and thereby keeping the lateral portion (48) of the ball retainer (44) close to the sidewall (32) of the longitudinally extending main body of the first rail (20).

7. System according to claim 6, wherein the projecting block (50) on the sidewall (40) of the longitudinally extending main body of the second rail (22) comprises an inclined surface (64) and a pushing surface (66), and when the second rail (22) is pulled in a longitudinal direction (F) relative to the first rail (20), the lateral portion (48) of the ball retainer (44) is guided by the inclined surface (64) in order for the pushing surface (66) to push the lateral portion (48) of the ball retainer (44).

8. System according to claim 6, wherein the mounting member (18) comprises a first end portion (70) and a second end portion (72) opposite to the first end portion (70), the first end portion (70) being connected to the lateral side (14) of the chassis (12), the second end portion (72) being mounted at the mounting portion (42) of the sidewall (40) of the longitudinally extending main body of the second rail (22), the second end portion (72) being located between the sidewall (40) of the longitudinally extending main body of the second rail (22) and the sidewall (32) of the longitudinally extending main body of the first rail (20) when mounted at the mounting portion (42) of the sidewall (40) of the longitudinally extending main body of the second rail (22), there being a first distance (L1) between a wall surface (74) of the sidewall (40) of the longitudinally extending main body of the second rail (22) and a surface (76) of the second end portion (72) of the mounting member (18), there being a second distance (L2) between the wall surface (74) of the sidewall (40) of the longitudinally extending main body of the second rail (22) and a pushing surface (66) of the projecting block (50), the second distance (L2) being greater than the first distance (L1), the pushing surface (66) being provided to push the lateral portion (48) of the ball retainer (44).

9. System according to claim 6, further comprising a third rail (24), the third rail (24) comprising an upper wall (52), a lower wall (54) opposite to the upper wall (52), and a sidewall (56) connected between the upper wall (52) and the lower wall (54), wherein the upper wall (52), the lower wall (54), and the sidewall (56) of the third rail (24) define a longitudinal channel (58), the first rail (20) being slidably connected in the longitudinal channel (58) of the third rail (24).

## Patentansprüche

1. Ein System, das eine Laufschienenmontage (10) umfasst,
die Laufschienenmontage (10), umfassend:
eine erste Schiene (20) mit einem sich länglich erstreckenden Hauptteil;
eine zweite Schiene (22) mit einem sich länglich erstreckenden Hauptteil und die verschiebbar an dem sich länglich erstreckenden Hauptteil der ersten Schiene (20) befestigt ist; und
einen Kugelkranz (26), der einen Kugelkäfig (44) und mehrere Kugeln (46),
die im Kugelkäfig (44) angeordnet sind, umfasst; der Kugelkranz (26) beweglich zwischen der ersten Schiene (20) und der zweiten Schiene (22) montiert ist; der Kugelkäfig (44) einen Seitenteil (48) umfasst, dessen Position mit einem Raum zwischen dem sich länglich erstreckenden Hauptteil der ersten Schiene (20) und dem sich länglich erstreckenden Hauptteil der zweiten Schiene (22) übereinstimmt;
wobei der sich länglich erstreckende Hauptteil der zweiten Schiene (22) weiter einen vorstehenden Block (50) umfasst, mit dem der Seitenteil (48) des Kugelkäfigs (44) angeschoben wird, um so den Seitenteil (48) des Kugelkäfigs (44) nahe zum sich länglich erstreckenden Hauptteil der ersten Schiene (20) zu halten,
wobei die zweite Schiene (22) eine obere Wand (36), eine untere Wand (38) gegenüber der oberen Wand (36) und eine Seitenwand (40), die zwischen der oberen Wand (36) und der unteren Wand (38) gebildet ist, aufweist, wobei die Seitenwand (40) der zweiten Schiene (22) mindestens einen Montageteil (42) aufweist, während ein Blockelement (43) an der Seitenwand (40) der zweiten Schiene (22) montiert ist,
**dadurch gekennzeichnet,**
**dass** das System weiter ein Fahrgestell (12) und dieses Fahrgestell (12) ein Montageglied (18) umfasst, und
**dass** mindestens ein Montageteil (42) an das Montageglied (18) montiert wird, wobei dieses Montageglied (18) auf mindestens einer lateralen Seite des auf die zweite Schiene (22) der Laufschienenmontage (10) zu befestigenden Fahrgestells (12) vorgesehen ist, und
**dass** das Blockelement (43) an das Montageglied (18) angedrückt werden kann, wenn das Montageglied (18) an das Montageteil (42) der Seitenwand (40) der zweiten Schiene (22) montiert wird.

2. System nach Anspruch 1, wobei die Laufschienenmontage (10) zum Montieren einer lateralen Seite (14) des Fahrgestells (12) an ein Gestell (16) dient; an der lateralen Seite (14) des Fahrgestells (12) das mindestens eine Montageglied (18) montiert ist; und wobei das Montageglied (18) einen ersten Endabschnitt (70) und einen zweiten Endabschnitt (72) gegenüber dem ersten Endabschnitt (70) aufweist; der erste Endabschnitt (70) an der lateralen Seite (14) des Fahrgestells (12) befestigt ist; der zweite Endabschnitt (72) quer am sich länglich erstreckenden Hauptteil der zweiten Schiene (22) montiert ist; der zweite Endabschnitt (72) beim queren Montieren am sich länglich erstreckenden Hauptteil der zweiten Schiene (22) zwischen dem sich länglich erstreckenden Hauptteil der zweiten Schiene (22) und dem sich länglich erstreckenden Hauptteil der ersten Schiene (20) vorgesehen ist; ein erster Querabstand (L1) zwischen einer Wandfläche (74) des sich länglich erstreckenden Hauptteils der zweiten Schiene (22) und einer Oberfläche (76) des zweiten Endabschnitts (72) des Montageglieds (18) vorhanden ist; ein zweiter Querabstand (L2) zwischen der Wandfläche (74) des sich länglich erstreckenden Hauptteils der zweiten Schiene (22) und einer Schubfläche (66) des vorstehenden Blocks (50) vorhanden ist; der zweite Abstand (L2) größer als der erste Abstand (L1) ist.

3. System nach Anspruch 1, wobei der sich länglich erstreckende Hauptteil der ersten Schiene (20) eine obere Wand (28), eine untere Wand (30) gegenüber der oberen Wand (28) und eine Seitenwand (32), die zwischen der oberen Wand (28) und der unteren Wand (30) gebildet ist, umfasst; und wobei die obere Wand (28), die untere Wand (30) und die Seitenwand (32) des sich länglich erstreckenden Hauptteils der ersten Schiene (20) einen Längskanal (34) bilden;
wobei der sich länglich erstreckende Hauptteil der zweiten Schiene (22) verschiebbar im Längskanal (34) der ersten Schiene (20) aufgenommen ist und eine obere Wand (36), eine untere Wand (38) gegenüber der oberen Wand (36) und eine Seitenwand (40), die zwischen der oberen Wand (36) und der unteren Wand (38) gebildet ist, umfasst; die Seitenwand (40) des sich länglich erstreckenden Hauptteils der zweiten Schiene (22) einen Montageteil (42) umfasst;
wobei die Position des Seitenteils (48) des Kugelkäfigs (44) mit einem Raum zwischen der Seitenwand (32) und dem sich länglich erstreckenden Hauptteils der ersten Schiene (20) und der Seitenwand (40) des sich länglich erstreckenden Hauptteils der zweiten (22) übereinstimmt; und
wobei der vorstehende Block (50) an der Seitenwand (40) des sich länglich erstreckenden Hauptteils der zweiten Schiene (22) vorgesehen ist, um den Seitenteil (48) des Kugelkäfigs (44) anzuschieben und somit den Seitenteil (48) des Kugelkäfigs (44) nahe zur Seitenwand (32) des sich länglich erstreckenden Hauptteils der ersten Schiene (20) zu halten.

4. System nach Anspruch 3, wobei der vorstehende Block (50) an der Seitenwand (40) des sich länglich erstreckenden Hauptteils der zweiten Schiene (22) eine schräge Fläche (64) und eine Schubfläche (66) aufweist; beim Ziehen der zweiten Schiene (22) in eine Längsrichtung (F) relativ zur ersten Schiene (20) der Seitenteil (48) des Kugelkäfigs (44) mit der schrägen Fläche (64) geführt wird, um den Seitenteil (48) des Kugelkäfigs (44) mit der Schubfläche (66) anzuschieben.

5. System nach Anspruch 3, weiter umfassend eine dritte Schiene (24); die dritte Schiene (24) eine obere Wand (52), eine untere Wand (54) gegenüber der oberen Wand (52) und eine Seitenwand (56), die zwischen der oberen Wand (52) und der unteren Wand (54) gebildet ist, umfasst; wobei die obere Wand (52), die untere Wand (54) und die Seitenwand (56) der dritten Schiene (24) einen Längskanal (58) bilden; die erste Schiene (20) verschiebbar im Längskanal (58) der dritten Schiene (24) befestigt ist.

6. System nach Anspruch 1, wobei die Laufschienenmontage (10) zum Montieren einer lateralen Seite (14) des Fahrgestells (12) an ein Gestell (16) dient; an der lateralen Seite (14) des Fahrgestells (12) mindestens ein Montageglied (18) vorgesehen ist;
wobei der sich länglich erstreckende Hauptteil der ersten Schiene (20) eine obere Wand (28), eine untere Wand (30) gegenüber der oberen Wand (28) und eine Seitenwand (32), die zwischen der oberen Wand (28) und der unteren Wand (30) gebildet ist, umfasst; und wobei die obere Wand (28), die untere Wand (30) und die Seitenwand (32) des sich länglich erstreckenden Hauptteils der ersten Schiene (20) einen Längskanal (34) bilden;
wobei der sich länglich erstreckende Hauptteil der zweiten Schiene (22) verschiebbar im Längskanal (34) der ersten Schiene (20) aufgenommen ist und eine obere Wand (36), eine untere Wand (38) gegenüber der oberen Wand (36) und eine Seitenwand (40), die zwischen der oberen Wand (36) und der unteren Wand (38) gebildet ist, umfasst; die Seitenwand (40) des sich länglich erstreckenden Hauptteils der zweiten Schiene (22) einen an das Montageglied (18) auf der lateralen Seite (14) des Fahrgestells (12) zu befestigenden Montageteil (42) aufweist;
wobei die Position des Seitenteils (48) des Kugelkäfigs (44) mit einem Raum zwischen der Seitenwand (32) des sich länglich erstreckenden Hauptteils der ersten Schiene (20) und der Seitenwand (40) des sich länglich erstreckenden Hauptteils der zweiten Schiene (22) übereinstimmt; und
wobei der vorstehende Block (50) an der Seitenwand (40) des sich länglich erstreckenden Hauptteils der zweiten Schiene (22) vorgesehen ist, um den Seitenteil (48) des Kugelkäfigs (44) anzuschieben und somit den Seitenteil (48) des Kugelkäfigs (44) nahe zur Seitenwand (32) des sich länglich erstreckenden Hauptteils der ersten Schiene (20) zu halten.

7. System nach Anspruch 6, wobei der vorstehende Block (50) an der Seitenwand (40) des sich länglich erstreckenden Hauptteils der zweiten Schiene (22) eine schräge Fläche (64) und eine Schubfläche (66) aufweist;
beim Ziehen der zweiten Schiene (22) in eine Längsrichtung (F) relativ zur ersten Schiene (20) der Seitenteil (48) des Kugelkäfigs (44) mit der schrägen Fläche (64) geführt wird, um den Seitenteil (48) des Kugelkäfigs (44) mit der Schubfläche (66) anzuschieben.

8. System nach Anspruch 6, wobei das Montageglied (18) einen ersten Endabschnitt (70) und einen zweiten Endabschnitt (72) gegenüber dem ersten Endabschnitt (70) aufweist; der erste Endabschnitt (70) an der lateralen Seite (14) des Fahrgestells (12) befestigt ist; der zweite Endabschnitt (72) am Montageteil (42) der Seitenwand (40) des sich länglich erstreckenden Hauptteils der zweiten Schiene (22) montiert ist; der zweite Endabschnitt (72) beim Montieren am Montageteil (42) der Seitenwand (40) des sich länglich erstreckenden Hauptteils der zweiten Schiene (22) zwischen der Seitenwand (40) des sich länglich erstreckenden Hauptteils der zweiten Schiene (22) und der Seitenwand (32) des sich länglich erstreckenden Hauptteils der ersten Schiene (20) vorgesehen ist; ein erster Abstand (L1) zwischen einer Wandfläche (74) der Seitenwand (40) des sich länglich erstreckenden Hauptteils der zweiten Schiene (22) und einer Oberfläche (76) des zweiten Endabschnitts (72) des Montageglieds (18) vorgesehen ist; ein zweiter Abstand (L2) zwischen der Wandfläche (74) der Seitenwand (40) des sich länglich erstreckenden Hauptteils der zweiten Schiene (22) und einer Schubfläche (66) des vorstehenden Blocks (50) vorgesehen ist; der zweite Abstand (L2) größer als der erste Abstand (L1) ist; mit der Schubfläche (66) der Seitenteil (48) des Kugelkäfigs (44) angeschoben wird.

9. System nach Anspruch 6, weiter umfassend eine dritte Schiene (24); die dritte Schiene (24) eine obere Wand (52), eine untere Wand (54) gegenüber der oberen Wand (52) und eine Seitenwand (56), die zwischen der oberen Wand (52) und der unteren Wand (54) gebildet ist, aufweist; wobei die obere Wand (52), die untere Wand (54) und die Seitenwand (56) der dritten Schiene (24) einen Längskanal (58) bilden; die erste Schiene (20) verschiebbar im Längskanal (58) der dritten Schiene (24) befestigt ist.

## Revendications

1. Système **caractérisé par le fait qu'**il comprend un ensemble de glissières (10), l'ensemble de glissières (10), **caractérisé par le fait qu'**il comprend :
un premier rail (20) présentant un corps principal s'étendant longitudinalement ;
un deuxième rail (22) présentant un corps principal s'étendant longitudinalement et raccordé de manière coulissante au corps principal s'étendant longitudinalement du premier rail (20) ; et
un ensemble à billes (26) **caractérisé par le fait qu'**il comprend un dispositif de retenue de billes (44) et une pluralité de billes (46) disposées dans le dispositif de retenue de billes (44), l'ensemble à billes (26) étant monté de manière mobile entre le premier rail (20) et le deuxième rail (22), le dispositif de retenue de billes (44) **caractérisé par le fait qu'**il comprend une partie latérale (48) correspondant en position à un espace entre le corps principal s'étendant longitudinalement du premier rail (20) et le corps principal s'étendant longitudinalement du deuxième rail (22) ;
le corps principal s'étendant longitudinalement du deuxième rail (22) **caractérisé par le fait qu'**il comprend en outre un bloc saillant (50) pour pousser la partie latérale (48) du dispositif de retenue de billes (44) et conservant ainsi la partie latérale (48) du dispositif de retenue de billes (44) près du corps principal s'étendant longitudinalement du premier rail (20),
le deuxième rail (22) comporte une paroi supérieure (36), une paroi inférieure (38) en face de la paroi supérieure (36), et une paroi latérale (40) raccordée entre la paroi supérieure (36) et la paroi inférieure (38), **caractérisé par le fait que** la paroi latérale (40) du deuxième rail (22) présente au moins une partie de montage (42), et un élément de blocage (43) est monté sur la paroi latérale (40) du deuxième rail (22),
**caractérisé par le fait,**
**que** le système est **caractérisé par le fait qu'**il comprend en outre un châssis (12), le châssis (12) comprend un élément de montage (18), et
que la ou les parties de montage (42) sont configurées pour être montées sur l'élément de montage (18) disposé sur au moins un côté latérale du châssis (12) pour être raccordées et attachées au deuxième rail (22) de l'ensemble de glissières (10), et
que l'élément de blocage (43) peut être pressé contre l'élément de montage (18) lorsque l'élément de montage (18) est monté sur la partie de montage (42) de la paroi latérale (40) du deuxième rail (22).

2. Système selon la revendication 1, **caractérisé par le fait que** l'ensemble de glissières (10) est équipé pour monter un côté latéral (14) du châssis (12) sur un rack (16), le côté latéral (14) du châssis (12) étant équipé d'un ou d'éléments de montage (18), et **caractérisé par le fait que** l'élément de montage (18) comprend une première partie terminale (70) et une seconde partie terminale (72) en face de la première partie terminale (70), la première partie terminale (70) étant raccordée au côté latéral (14) du châssis (12), la seconde partie terminale (72) étant montée transversalement sur le corps principal s'étendant longitudinalement du deuxième rail (22), la seconde partie terminale (72) étant située entre le corps principal s'étendant longitudinalement du deuxième rail (22) et le corps principal s'étendant longitudinalement du premier rail (20) lorsque montée transversalement sur le corps principal s'étendant longitudinalement du deuxième rail (22), une première distance transversale (L1) étant placée entre une surface de paroi (74) du corps principal s'étendant longitudinalement du deuxième rail (22) et une surface (76) de la seconde partie terminale (72) de l'élément de montage (18), une seconde distance transversale (L2) étant placée entre la surface de paroi (74) du corps principal s'étendant longitudinalement du deuxième rail (22) et une surface de poussée (66) du bloc saillant (50), la seconde distance (L2) étant supérieure à la première distance (L1).

3. Système selon la revendication 1, **caractérisé par le fait que** le corps principal s'étendant longitudinalement du premier rail (20) comprend une paroi supérieure (28), une paroi inférieure (30) en face de la paroi supérieure (28), et une paroi latérale (32) raccordée entre la paroi supérieure (28) et la paroi inférieure (30), et **caractérisé par le fait que** la paroi supérieure (28), la paroi inférieure (30), et la paroi latérale (32) du corps principal s'étendant longitudinalement du premier rail (20) définissent un conduit longitudinal (34) ;
le corps principal s'étendant longitudinalement du deuxième rail (22) est reçu de manière coulissante dans le conduit longitudinal (34) du premier rail (20) et comprend une paroi supérieure (36), une paroi inférieure (38) en face de la paroi supérieure (36), et la paroi latérale (40) raccordée entre la paroi supérieure (36) et la paroi inférieure (38), la paroi latérale (40) du corps principal s'étendant longitudinalement du deuxième rail (22) comprenant la partie de montage (42) ;
la partie latérale (48) du dispositif de retenue de billes (44) correspond en position à un espace entre la paroi latérale (32) du corps principal s'étendant longitudinalement du premier rail (20) et la paroi latérale (40) du corps principal s'étendant longitudinalement du deuxième rail (22) ; et
le bloc saillant (50) est situé sur la paroi latérale (40) du corps principal s'étendant longitudinalement du deuxième rail (22) pour pousser la partie latérale (48) du dispositif de retenue de billes (44) et conservant ainsi la partie latérale (48) du dispositif de retenue de billes (44) près de la paroi latérale (32) du corps principal s'étendant longitudinalement du premier rail (20).

4. Système selon la revendication 3, **caractérisé par le fait que** le bloc saillant (50) sur la paroi latérale (40) du corps principal s'étendant longitudinalement du deuxième rail (22) comprend une surface inclinée (64) et une surface de poussée (66), et lorsque le deuxième rail (22) est tiré dans une direction longitudinale (F) relative au premier rail (20), la partie latérale (48) du dispositif de retenue de billes (44) est guidée par la surface inclinée (64) afin de permettre à la surface de poussée (66) de pousser la partie latérale (48) du dispositif de retenue de billes (44).

5. Système selon la revendication 3, **caractérisé par le fait qu'**il comprend en outre un troisième rail (24), le troisième rail (24) **caractérisé par le fait qu'**il comprend une paroi supérieure (52), une paroi inférieure (54) en face de la paroi supérieure (52), et une paroi latérale (56) raccordée entre la paroi supérieure (52) et la paroi inférieure (54), **caractérisé par le fait que** la paroi supérieure (52), la paroi inférieure (54), et la paroi latérale (56) du troisième rail (24) définissent un conduit longitudinal (58), le premier rail (20) étant raccordé de manière coulissante dans le conduit longitudinal (58) du troisième rail (24).

6. Système selon la revendication 1, **caractérisé par le fait que** l'ensemble de glissières (10) est équipé pour monter un côté latéral (14) du châssis (12) sur un rack (16), le côté latéral (14) du châssis (12) étant équipé d'un ou d'éléments de montage (18) ;
le corps principal s'étendant longitudinalement du premier rail (20) comprend une paroi supérieure (28), une paroi inférieure (30) en face de la paroi supérieure (28), et une paroi latérale (32) raccordée entre la paroi supérieure (28) et la paroi inférieure (30), et **caractérisé par le fait que** la paroi supérieure (28), la paroi inférieure (30), et la paroi latérale (32) du corps principal s'étendant longitudinalement du premier rail (20) définissent un conduit longitudinal (34) ;
le corps principal s'étendant longitudinalement du deuxième rail (22) est reçu de manière coulissante dans le conduit longitudinal (34) du premier rail (20) et comprend une paroi supérieure (36), une paroi inférieure (38) en face de la paroi supérieure (36), et la paroi latérale (40) raccordée entre la paroi supérieure (36) et la paroi inférieure (38), la paroi latérale (40) du corps principal s'étendant longitudinalement du deuxième rail (22) comprenant la partie de montage (42) pour être monté sur l'élément de montage (18) sur le côté latéral (14) du châssis (12) ;
la partie latérale (48) du dispositif de retenue de billes (44) correspond en position à un espace entre la paroi latérale (32) du corps principal s'étendant longitudinalement du premier rail (20) et la paroi latérale (40) du corps principal s'étendant longitudinalement du deuxième rail (22) ; et
le bloc saillant (50) est situé sur la paroi latérale (40) du corps principal s'étendant longitudinalement du deuxième rail (22) pour pousser la partie latérale (48) du dispositif de retenue de billes (44) et conservant ainsi la partie latérale (48) du dispositif de retenue de billes (44) près de la paroi latérale (32) du corps principal s'étendant longitudinalement du premier rail (20).

7. Système selon la revendication 6, **caractérisé par le fait que** le bloc saillant (50) sur la paroi latérale (40) du corps principal s'étendant longitudinalement du deuxième rail (22) comprend une surface inclinée (64) et une surface de poussée (66), et lorsque le deuxième rail (22) est tiré dans une direction longitudinale (F) relative au premier rail (20), la partie latérale (48) du dispositif de retenue de billes (44) est guidée par la surface inclinée (64) afin de permettre à la surface de poussée (66) de pousser la partie latérale (48) du dispositif de retenue de billes (44).

8. Système selon la revendication 6, **caractérisé par le fait que** l'élément de montage (18) comprend une première partie terminale (70) et une seconde partie terminale (72) en face de la première partie terminale (70), la première partie terminale (70) étant raccordée au côté latéral (14) du châssis (12), la seconde partie terminale (72) étant montée sur la partie de montage (42) de la paroi latérale (40) du corps principal s'étendant longitudinalement du deuxième rail (22), la seconde partie terminale (72) étant située entre la paroi latérale (40) du corps principal s'étendant longitudinalement du deuxième rail (22) et la paroi latérale (32) du corps principal s'étendant longitudinalement du premier rail (20) lorsque montée sur la partie de montage (42) de la paroi latérale (40) du corps principal s'étendant longitudinalement du deuxième rail (22), une première distance (L1) étant placée entre une surface de paroi (74) de la paroi latérale (40) du corps principal s'étendant longitudinalement du deuxième rail (22) et une surface (76) de la seconde partie terminale (72) de l'élément de montage (18), une seconde distance (L2) étant placée entre la surface de paroi (74) de la paroi latérale (40) du corps principal s'étendant longitudinalement du deuxième rail (22) et une surface de poussée (66) du bloc saillant (50), la seconde distance (L2) étant supérieure à la première distance (L1), la surface de poussée (66) servant à pousser la partie latérale (48) du dispositif de retenue de billes (44).

9. Système selon la revendication 6, **caractérisé par le fait qu'**il comprend en outre un troisième rail (24), le troisième rail (24) **caractérisé par le fait qu'**il comprend une paroi supérieure (52), une paroi inférieure (54) en face de la paroi supérieure (52), et une paroi latérale (56) raccordée entre la paroi supérieure (52) et la paroi inférieure (54), **caractérisé par le fait que** la paroi supérieure (52), la paroi inférieure (54), et la paroi latérale (56) du troisième rail (24) définissent un conduit longitudinal (58), le premier rail (20) étant raccordé de manière coulissante dans le conduit longitudinal (58) du troisième rail (24).
